# EUROPEAN PATENT APPLICATION

(11) **EP 0 949 692 A2**
(43) Date of publication of application: **13.10.1999**
(21) Application number: 99105153.3
(22) Date of filing: 29.03.1999
(51) Int. Cl.: H01L 39/24

(54) **Oxide superconductor and method of treating the surface thereof**

(30) Priority: 30.03.1998 JP 8347698; 29.07.1998 JP 21428398
(71) Applicant: INTERNATIONAL SUPERCONDUCTIVITY TECHNOLOGY CENTER, Tokyo 105 (JP)
(72) Inventor: Tanaka, Nobue Intern. Superconductivity Techn., 14-3, Shinonome 1-chome, Koto-ku, Tokyo (JP); Zama, Hideaki Intern. Superconductivity Techn., 14-3, Shinonome 1-chome, Koto-ku, Tokyo (JP); Morishita, Tadataka Intern.Superconductivity Tech., 14-3, Shinonome 1-chome, Koto-ku, Tokyo (JP)
(74) Representative: Beetz & Partner Patentanwälte

(57) **Abstract**

When a surface (10) of the YBCO (1) which is an oxide superconductor is performed of a grinding process Gr so as to flatten its surface, a deterioration layer damaged by the process remains on the surface. When a heat treatment is performed to the surface including the deterioration layer so as to provide superconductivity, the deterioration layer is dissolved, thereby generating particles (60), which deteriorate the surface roughness of the superconductor. By immersing the surface of the superconductor in a hydrogen chloride methanol liquid having a concentration of 0.01% for 10 seconds before the heat treatment, the deterioration layer may be removed, and a stabilized surface may be gained.

## Description

### FIELD OF THE INVENTION

The present invention relates to an oxide superconductor comprising a surface treated to have stability against heating steps while laminating thin-film layers and the like, by removing a deterioration layer on the surface of the superconductor having instability under the atmosphere, said deterioration layer being generated when performing a mechanical process such as grinding or ion milling to the surface of the oxide superconductor. The present invention also relates to a method of treating the surface of the oxide superconductor so as to provide such stability.

### DESCRIPTION OF THE RELATED ART

The surface of an oxide superconductor whose composition may be shown by the chemical formula of M'Ba₂Cu₃O_{7-δ} (wherein M' designates a rare-earth element such as Y, Nd, Sm, Eu or alloys thereof, and δ is the amount of oxygen depletion) with an atomic-scale flatness is provided through mechanical processes such as grinding. However, in order for the oxide superconductor to show good superconductivity, there is a need to permeate sufficient oxygen to the oxide superconductor by providing a heat treatment thereto under an oxygen atmosphere after the grinding. When doing so, there was a problem that many fine particles were deposited on the ground surface, which deteriorated the surface flatness greatly. Further, when performing the grinding process to the superconductor after the heat treatment, there was a need to permeate (diffuse) oxygen to a deeper depth including the portion to be removed as grind base, which demanded longer heat treatment.

Moreover, an oxide non-superconductor whose composition may be shown by the chemical formula of M*Ba₂Cu₃O_{7-δ} (wherein M* designates an element of Pr or Sc or alloys thereof, and δ is the amount of oxygen depletion) is an important element when forming a superconducting element by laminating the oxide non-superconductor with an oxide superconductor and the like. However, the non-superconductor must also be heat treated during the lamination process, and it also had the problem that fine particles were deposited on the surface thereof.

When fine particles are deposited on the surface of the element, the composition on the surface of the element may not be identified, so there was a problem that the chemical characteristics in the surface of the element may not be controlled with good repeatability.

### SUMMARY OF THE INVENTION

The present invention relates to providing an oxide superconductor whose surface having an atomic-level flatness will not be deteriorated, since the cause of particles being deposited on the surface of the oxide superconductor during the heat treatment is removed.

Moreover, the present invention aims at providing an oxide superconductor wherein the surface of the oxide superconductor is flattened in an atomic level, and said surface is covered by steps of crystal surfaces having a step height of 1.2 nm (12 angstrom) which is the length of a unit cell along (001), and the atoms at the uppermost surface is identified.

The present invention discloses an oxide superconductor having a composition shown by the chemical formula of M'Ba₂Cu₃O_{7-δ} (wherein M' designates a rare-earth element such as Y, Nd, Sm, Eu or alloys thereof, and δ is the amount of oxygen depletion), wherein said oxide superconductor includes a surface provided with a chemical treatment so that said surface is stabilized against heat treatment and which will not deposit particles.

Moreover, the oxide superconductor according to the present invention has a (001) surface, and the uppermost surface thereof is formed of Cu atoms and O atoms.

Moreover, the atomic surface next to the uppermost surface is formed of M'.

Further, the present invention discloses an oxide non-superconductor having a composition shown by the chemical formula of M*Ba₂Cu₃O_{7-δ} (wherein M* designates an element of Pr or Sc or alloys thereof, and δ is the amount of oxygen depletion), wherein said oxide non-superconductor includes a chemically treated surface so that said surface is stabilized against heat treatment and which will not deposit particles.

Moreover, the oxide non-superconductor according to the present invention has a (001) surface, and the uppermost surface thereof is formed of Cu atoms and O atoms.

Moreover, the atomic surface next to the uppermost surface is formed of M*.

Even further, the treating method according to the present invention relates to a chemical treatment method for stabilizing the surface of an oxide superconductor having a composition shown by a chemical formula of M'Ba₂Cu₃O_{7-δ} (wherein M' designates a rare-earth element such as Y, Nd, Sm, Eu or alloys thereof, and δ is the amount of oxygen depletion) or an oxide non-superconductor having a composition shown by a chemical formula of M*Ba₂Cu₃O_{7-δ} (wherein M* designates an element of Pr or Sc or alloys thereof, and δ is the amount of oxygen depletion), wherein said surface is immersed in hydrogen chloride methanol having a concentration of 0.01% for 10 seconds.

### BRIEF DESCRIPTION OF THE DRAWINGS

FIG. 1 is an explanatory view showing the single-layer structure and the integrated structure of the oxide superconductor;
FIG. 2 is a typified drawing of the image by an AFM observing the surface of a single-layer;
FIG. 3 is a graph showing the surface roughness of FIG. 2 taken along lines L₁ and L₂;
FIG. 4 is an explanatory view inferring the reason why the surface roughness is varied;
FIG. 5 is a typified drawing of the image by an AFM observing the surface after the heat treatment;
FIG. 6 is a graph showing the measured result of the surface roughness of FIG. 5 taken along lines L₃ and L₄;
FIG. 7 is a typified drawing of the surface which has not been performed of the treatment;
FIG. 8 is a typified drawing of the surface after the treatment;
FIG. 9 is an optoelectronic spectral drawing of a Cu2p, each showing the state where no treatment is performed, where the chemical treatment is performed, and where the heat treatment is performed;
FIG. 10 is an image and a line profile gained by observing the (001) surface of the YBCO by AFM which has been performed of the chemical treatment according to the present invention;
FIG. 11 is a drawing showing the unit cell of M'Ba₂Cu₃O_{7-δ} and M*Ba₂Cu₃O_{7-δ};
FIG. 12 is a drawing showing the result of the optoelectronic spectral of the total reflection x-ray; and
FIG. 13 is an explanatory view showing the laminated structure according to the present invention.

### PREFERRED EMBODIMENT OF THE INVENTION

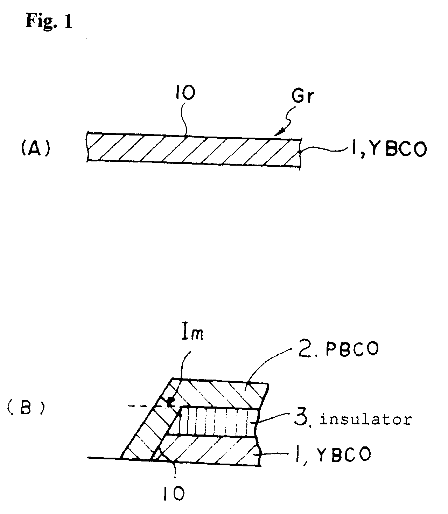

FIG. 1 (A) is an explanatory view showing a single-layer structure of an oxide superconductor with a so-called 123 structure (hereinafter called YBCO) represented by YBa₂Cu₃O_{7-δ} (δ is the amount of oxygen depletion).

A grinding process Gr and the like is performed to the surface 10 of an oxide superconductor 1, so as to secure the flatness of its surface.

Further, FIG. 1(B) shows an insulator 3 being laminated on the upper surface of the YBCO layer 1, and an oxide non-superconductor with a so-called 123 structure (hereinafter called PBCO) represented by PrBa₂Cu₃O_{7-δ} (δ is the amount of oxygen depletion) being laminated on the insulator 3, thereby forming a ramp portion 10, and creating a Josephson junction by an ion milling process Im.

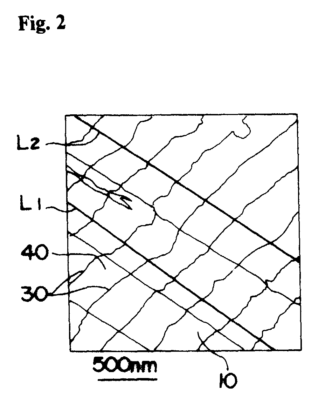

FIG. 2 is a typified drawing showing the image of the YBCO surface treated with a grinding process, which is observed by an atomic force microscope (AFM).

Each region 40 defined by borders 30 are terrace portions in the step structure formed of crystal surfaces of YBCO.

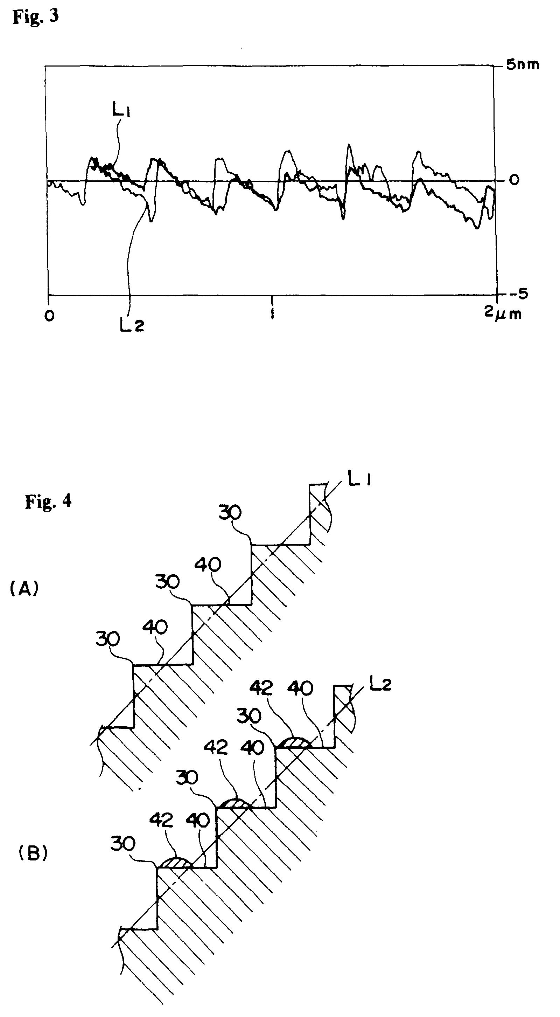

FIG. 3 shows the result of the line profile measuring the roughness of the YBCO surface along lines L₁ and L₂ observed in FIG. 2.

The result shows that the variation in the value of the surface roughness along line L₂ is greater than the surface roughness along line L₁.

FIG. 4 is an explanatory view inferring the reason why the surface roughness is varied.

FIG. 4(A) shows a typified cross-sectional structure of the crystal surface taken along line L₁. It is considered that the crystal surfaces 40 adjacent to each other in the level of atomic sizes appear in the state where no damage is done thereto.

FIG. 4(B) shows a typified cross-sectional structure of the crystal surface taken along line L₂. It is considered that a deterioration layer 42 appears on the crystal surface 40 which is thought to be generated by the damage from the grinding process.

The deterioration layer 42 is deposited to the surface of a, normal crystal surface 40, and during the heat treatment process, it is melted, and then hardened as particles.

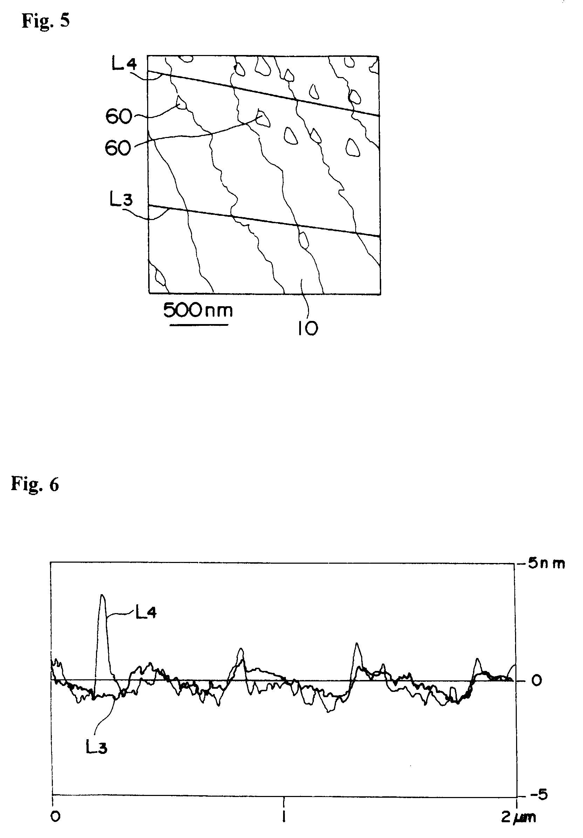

FIG. 5 is a typified drawing showing the AFM image of the surface of a YBCO including the deterioration layer shown in FIG. 2 after it has been heat treated for 30 minutes by a temperature of 700 °C under oxygen partial pressure of 3 Torr, which is necessary in providing superconductivity thereto. The image shows that particles 60 exist on the surface.

It is considered that particles 60 are generated by the deposition constituting the deterioration layer 42 being melted by heat treatment, and then hardened thereafter in forms of particles.

FIG. 6 shows the result of measuring the roughness of the surface shown in FIG. 5 along lines L₃ and L₄ as line profiles.

In comparison to the surface roughness measured along line L₃ which shows a regular step structure, the surface roughness measured along line L₄ is obviously deteriorated by the existence of particles 60.

When forming a laminated structure by laminating thin films on the surface of the oxide superconductor, the flatness of the boundary area is damaged by the existence of particles 60.

Therefore, the present invention aims at providing an oxide superconductor having a surface stabilized against heat treatment by providing a chemical treatment thereto so as to remove the deterioration layer. Further, the present invention aims at providing a method of chemically treating said oxide superconductor.

The chemical treatment performed to the oxide superconductor according to the present invention involves immersing the surface of the oxide superconductor which had gone through a grinding process in a hydrogen chloride methanol liquid having a concentration of 0.01% for 10 seconds.

The chemical treatment disclosed above removes the deterioration layer on the surface of the superconductor, and the surface is stabilized. The generation of particles are prevented even when a heat treatment is performed to the surface.

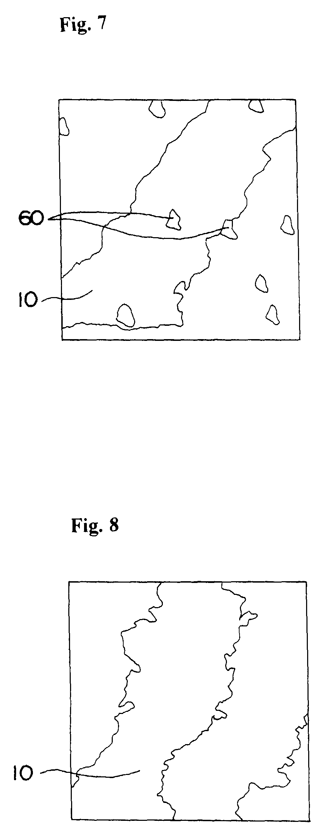

FIGS. 7 and 8 show typified drawings of AFM images comparing the YBCO surface which has been heat treated after being performed of a grinding process, and the YBCO surface which has been performed of the chemical treatment according to the present invention after the grinding process under the same condition.

FIG. 7 shows the surface where no chemical treatment is performed. Particles 60 appear on the surface thereof by the heat treatment.

FIG. 8 shows the surface where chemical treatment according to the present invention is performed before the heat treatment. It is confirmed by experiment that the cause of the particles are removed by the chemical treatment, and a stabilized surface may be gained.

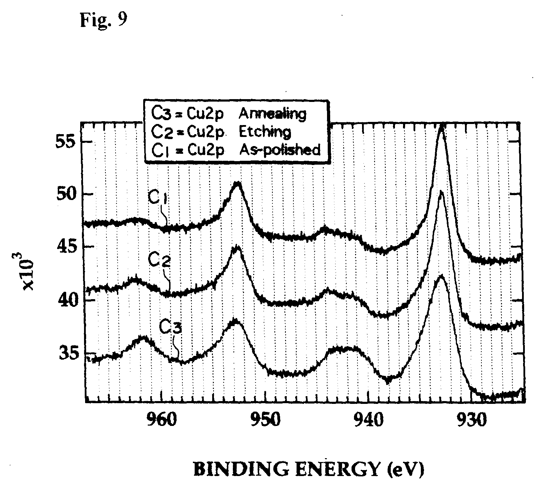

FIG. 9 shows an optoelectronic spectral of the surface atoms of Cu2p, wherein curve C₁ shows the untreated state, curve C₂ shows the chemically treated state according to the present invention, and curve C₃ shows the heat treated state.

From the present view, it is confirmed that the electronic structure of the surface atoms ate remarkably improved by the chemical treatment, and especially by the heat treatment.

The surface stabilization process explained above may also be adopted to the surface treatment of the ramp portion for manufacturing the Josephson junction explained in FIG. 1(B).

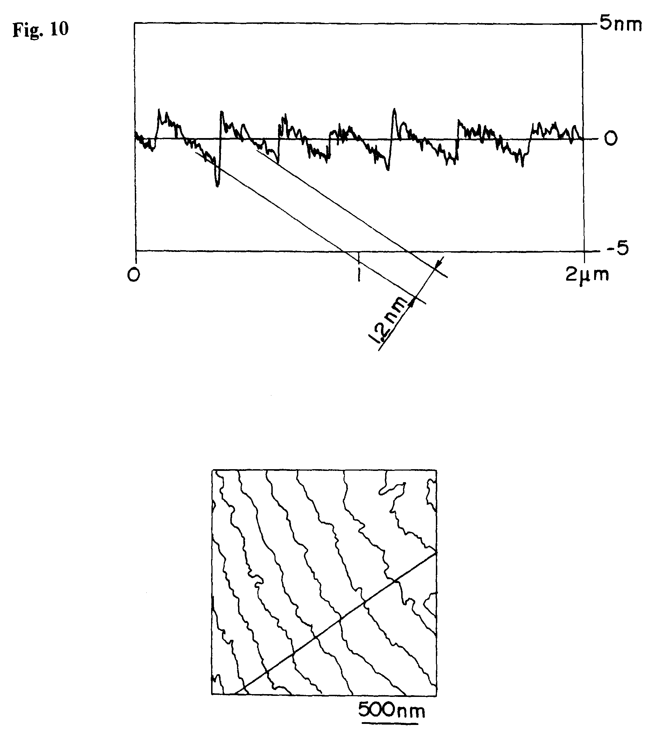

FIG. 10 shows the line profile and the image of the (001) surface of the YBCO performed of the heat treatment according to the present invention, which is observed through the AFM. It could be seen from the drawing that the whole surface is covered by steps of crystal surfaces having a step height of 1.2 nm (12 angstrom).

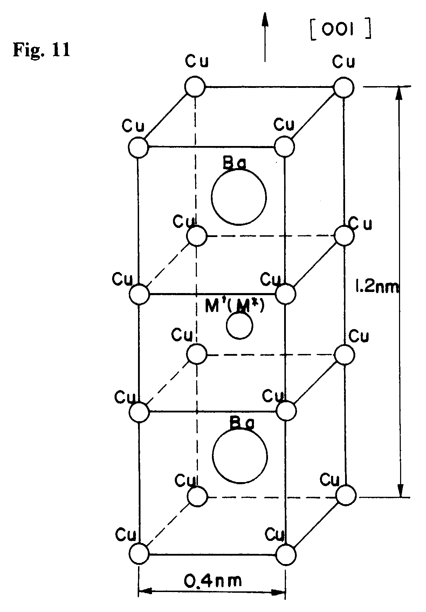

FIG. 11 shows a unit cell of M'Ba₂Cu₃O_{7-δ} and M*Ba₂Cu₃O_{7-δ}. In the drawing, a unit cell having Cu as the uppermost surface is shown. However, even with Ba or M' (M*) on the uppermost surface, the unit cell will similarly have a size of 1.2 nm. With any element on the uppermost surface, the same element will appear on the surface as long as it is covered by unit cell (1.2 nm) steps.

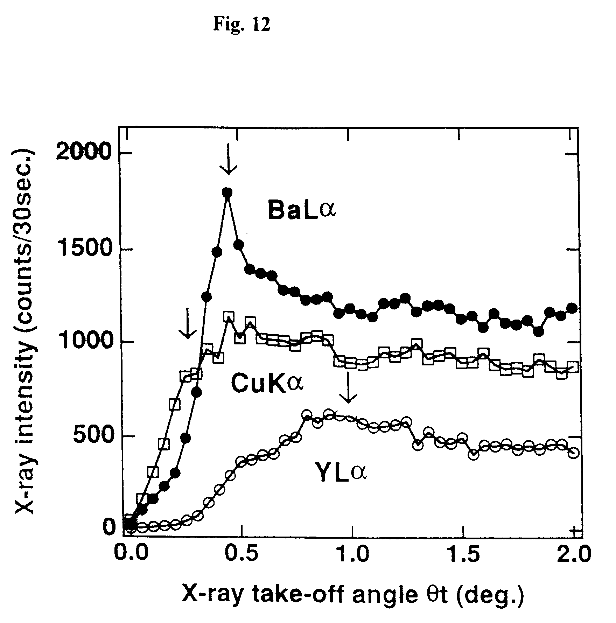

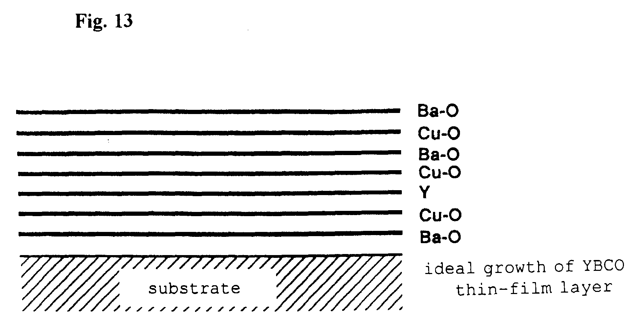

FIG. 12 shows the result of the optoelectronic spectral of the total reflection x-rays that the present inventors have measured formerly (J. Appl. Phys. 74,438 (1993)). The x-ray from Ba uniquely shows a sharp peak, which indicates the existence of Ba elements on the uppermost surface at the time the YBCO thin-film layer is completely formed. Accordingly, the structure of the YBCO thin-film is typically formed as shown in FIG. 13. The experiment shows the example where M' is Y, but it could be easily known by analogy that similar thin-film growth will occur for all M'Ba₂Cu₃O_{7-δ} and M*Ba₂Cu₃O_{7-δ}, since M' and M* have characters that are chemically alike.

When the chemical treatment according to the present invention is performed to the thin-film structure shown in FIG. 13, the atomic layer including Ba having very strong chemical reactivity is dissolved, thereby slowing the advancement of reaction in layers formed of Cu and O. Since steps of unit cells are observed at all times on the surface of the superconductor after the chemical treatment, it is considered that the aforementioned layer including Cu is the atomic layer comprising Cu and O which is adjacent to Y.

As explained above, according to the present invention, the residual deterioration layer formed on the crystal surface of the single crystal oxide superconductor when flattening the surface thereof by grinding, or the residual deterioration layer formed on the surface of the ramp portion generated by an ion milling process when forming a laminated superconducting element may be removed by a chemical treatment, thereby forming a stabilized surface. Accordingly, particles may be prevented from being generated on the surface thereof even by the heat treatment or by the lamination process providing superconductivity thereto.

Therefore, according to the present invention, a material having good superconducting characteristics and crystallinity may be gained. Such material enables to realize a laminated superconducting element or the integration of a superconducting element, as superconducting substrate material or superconducting ground plane, respectively.

Even further, the present invention contributes greatly to the improvement in the repeatability of integrating superconducting elements or laminated superconducting elements, by providing an oxide superconductor whose uppermost surface atom is identified.

## Claims

1. An oxide superconductor having a composition shown by a chemical formula of M'Ba₂Cu₃O_{7-δ} (wherein M' designates a rare-earth element such as Y, Nd, Sm, Eu or alloys thereof, and δ is the amount of oxygen depletion): wherein
the surface (10) of said oxide superconductor is stabilized by a chemical treatment performed thereto, and said oxide superconductor is performed of heat treatment thereafter so as to provide superconductivity thereto.

2. An oxide superconductor having a composition shown by a chemical formula of M'Ba₂Cu₃O_{7-δ} (wherein M' designates a rare-earth element such as Y, Nd, Sm, Eu or alloys thereof, and δ is the amount of oxygen depletion) and further having a (001) surface as the upper surface: wherein
the surface of said oxide superconductor is stabilized by a chemical treatment performed thereto, and the uppermost surface thereof is formed of Cu atoms and O atoms.

3. An oxide superconductor having a composition shown by a chemical formula of M'Ba₂Cu₃O_{7-δ} (wherein M' designates a rare-earth element such as Y, Nd, Sm, Eu or alloys thereof, and δ is the amount of oxygen depletion) and further having a (001) surface as the upper surface: wherein
the surface of said oxide superconductor is stabilized by a chemical treatment performed thereto, the uppermost surface thereof is formed of Cu atoms and O atoms, and the next atomic surface is formed of M'.

4. An oxide non-superconductor having a composition shown by a chemical formula of M*Ba₂Cu₃O_{7-δ} (wherein M* designates an element of Pr or Sc or alloys thereof, and δ is the amount of oxygen depletion): wherein
the surface of said oxide non-superconductor is stabilized against heat treatment by a chemical treatment performed thereto.

5. An oxide non-superconductor having a composition shown by a chemical formula of M*Ba₂Cu₃O_{7-δ} (wherein M* designates an element of Pr or Sc or alloys thereof, and δ is the amount of oxygen depletion) and further having a (001) surface as the upper surface: wherein
the surface of said oxide non-superconductor is stabilized by a chemical treatment performed thereto, and the uppermost surface thereof is formed of Cu atoms and O atoms.

6. An oxide non-superconductor having a composition shown by a chemical formula of M*Ba₂Cu₃O_{7-δ} (wherein M* designates an element of Pr or Sc or alloys thereof, and δ is the amount of oxygen depletion) and further having a (001) surface as the upper surface: wherein
the surface of said oxide non-superconductor is stabilized by a chemical treatment performed thereto, the uppermost surface thereof is formed of Cu atoms and O atoms, and the next atomic surface is formed of M*.

7. A method of chemically treating the surface (10) of an oxide superconductor having a composition shown by a chemical formula of M'Ba₂Cu₃O_{7-δ} (wherein M' designates a rare-earth element such as Y, Nd, Sm, Eu or alloys thereof, and δ is the amount of oxygen depletion) or an oxide non-superconductor having a composition shown by a chemical formula of M*Ba₂Cu₃O_{7-δ} (wherein M* designates an element of Pr or Sc or alloys thereof, and δ is the amount of oxygen depletion) so as to stabilize the surface of said oxide superconductor or said oxide non-superconductor: wherein
said surface is immersed in a hydrogen chloride methanol liquid having a concentration of 0.01% for 10 seconds.
